(19) Europäisches Patentamt / European Patent Office / Office européen des brevets

(11) **EP 4 446 768 A1**

(12) **EUROPEAN PATENT APPLICATION**
published in accordance with Art. 153(4) EPC

(43) Date of publication:
**16.10.2024 Bulletin 2024/42**

(21) Application number: **22902752.9**

(22) Date of filing: **13.06.2022**

(51) International Patent Classification (IPC):
**G01S 7/48** (2006.01)        **G01S 7/481** (2006.01)
**G01S 17/08** (2006.01)

(52) Cooperative Patent Classification (CPC):
**G01S 7/48; G01S 7/481; G01S 17/08;** Y02A 90/10

(86) International application number:
**PCT/CN2022/098331**

(87) International publication number:
**WO 2023/103314 (15.06.2023 Gazette 2023/24)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **09.12.2021  CN 202111503333**

(71) Applicant: **Hesai Technology Co., Ltd.
Shanghai 201821 (CN)**

(72) Inventors:
• **WU, You
  Shanghai 201821 (CN)**
• **XIANG, Shaoqing
  Shanghai 201821 (CN)**

(74) Representative: **Fish & Richardson P.C.
Highlight Business Towers
Mies-van-der-Rohe-Straße 8
80807 München (DE)**

(54) **DETECTION UNIT, DETECTION ARRAY, DETECTION ARRAY MOTHERBOARD, DETECTOR, AND LASER RADAR**

(57)    A detector unit, a detector array, a detector array motherboard, a detector, and a LiDAR. The detector unit includes: a photosensitive pixel including multiple photosensitive devices; and a microlens array located on a side of the photosensitive pixel, a light is incident on the side, and the microlens array includes multiple microlenses having a one-to-one relationship with the multiple photosensitive devices; a microlens of the multiple microlenses includes a protrusion, and a material of the protrusion is an inorganic material. An encapsulation material can contact with a surface of the microlens without retaining an air gap between the encapsulation material and the microlens, which can improve the reliability of the device effectively, and reduce the encapsulation difficulty. Particularly, for a vehicle device, reducing formation of the air gap is advantageous for passing vehicle regulation certification.

**FIG. 2**

EP 4 446 768 A1

# Description

This application claims priority to Chinese Patent Application No. 2021115033332 titled "DETECTOR UNIT, DETECTOR ARRAY, DETECTOR ARRAY MOTHERBOARD, DETECTOR, AND LIDAR" and filed with the China National Intellectual Property Administration on December 9, 2021, the content of which is incorporated herein by reference in its entirety.

## TECHNICAL FIELD

This disclosure relates to the field of light detection, and, in particular, to a detector unit, a detector array, a detector array motherboard, a detector, and a LiDAR.

## BACKGROUND

A LiDAR is a commonly used ranging sensor characterized by long detection range, high resolution, less environmental interference, or the like, and is widely used in the fields such as smart robots, unmanned aerial vehicles, autonomous driving, or the like. The working principle of the LiDAR is to use time a laser spent on travelling back and forth between a radar and a target, or a frequency shift generated by frequency modulated continuous light travelling back and forth between the radar and the target to evaluate information such as a distance or speed of the target, or the like.

Ranging performance is an important technical indicator of the LiDAR. With the introduction of a single photon detector device, such as silicon photomultiplier ("SiPM"), single photon avalanche diode ("SPAD"), or the like, into the LiDAR, stronger photon detection capability, higher sensitivity, and lower electronic noise make the single photon detector device increasingly favored by industry insiders.

In a photosensitive pixel using the single photon detector device, such as SiPM, SPAD, or the like, an area of a photosensitive region is much smaller than a pixel area, that is, a filling factor of the area of the photosensitive region relative to the pixel area is quite small, and only a light signal incident on the photosensitive region can be effectively detected. This limits detection efficiency of the photosensitive pixel. To improve the detection efficiency, a microlens array is usually provided on a surface of the photosensitive pixel to focus light on the photosensitive region.

However, even if the microlens array is provided, the detection efficiency of the detector unit still remains to be improved.

## SUMMARY

A problem to be solved in this disclosure is to provide a detector unit, a detector array, a detector array motherboard, a detector, and a LiDAR, to improve detection efficiency of the detector unit.

To solve the above problem, this disclosure provides a detector unit, including:
a photosensitive pixel including multiple photosensitive devices; and a microlens array located on a side of the photosensitive pixel, wherein a light is incident on the side and the microlens array includes multiple microlenses. The multiple microlenses have a one-to-one relationship with the multiple photosensitive devices; the microlens includes a protrusion, and a material of the protrusion is an inorganic material.

Optionally, the inorganic material is silicon.

Optionally, the microlens array is formed on a surface of the photosensitive pixel.

Optionally, a process of forming the microlens array includes: a deposition process.

Optionally, the microlens is a planar microlens.

Optionally, the microlens includes multiple protrusions, and the microlens is a diffractive lens.

Optionally, the microlens is at least one of a Fresnel zone plate and a metalens.

Optionally, the microlens can converge a light signal to a high electric field region of a corresponding photosensitive device.

Optionally, the photosensitive device is a back side illumination photosensitive device; the photosensitive device includes a first surface provided with an electrode and a second surface opposite to the first surface; and the microlens is located on a side of the second surface.

Optionally, the detector unit further includes: a reflective layer located on the first surface of the photosensitive device.

Optionally, the light signal is reflected from the first surface of the photosensitive device after transmitting through the microlens array and the photosensitive device sequentially.

Optionally, the photosensitive device is a front side illumination photosensitive device; the photosensitive device includes a first surface provided with an electrode and a second surface opposite to the first surface; and the microlens array is located on a side of the first surface.

Optionally, the microlens further includes: a filler layer located on the first surface of the photosensitive device.

Optionally, the material of the filler layer is a low light loss material.

Optionally, the material of the filler layer is silicon oxide.

Optionally, the detector unit further includes: a cladding material at least filling a gap between adjacent protrusions. A refractive index of the cladding material is lower than a refractive index of the material of the protrusions.

Optionally, a top surface of the cladding material is higher than a top surface of the protrusion.

Optionally, the detector unit further includes: an air gap located at least between adjacent protrusions.

Optionally, the detector unit further includes: an encapsulation layer located at least on the microlens array.

Optionally, the photosensitive device is a single photon detector device.

Optionally, the microlens can converge a light signal to a depletion layer of a corresponding photosensitive device.

Accordingly, this disclosure further provides a detector array, including: detector units arranged in an array. The detector units are the detector units described in this disclosure.

This disclosure further provides a detector array motherboard, including: multiple detector arrays. The detector arrays are the detector arrays described in this disclosure.

This disclosure further provides a detector, including: at least one detector array. The detector array is the detector array described in this disclosure.

This disclosure further provides a LiDAR, including: a light source used to generate light; and a detector used to receive echo light. The detector is the detector described in this disclosure.

Compared with the prior art, technical solutions of this disclosure have the following advantages:

In the technical solutions of this disclosure, the material of the protrusion used to converge light of the microlens is an inorganic material. A refractive index of the material of the protrusion is different from a refractive index of an encapsulation material of the detector unit. In such a case, encapsulation can be performed on a surface of the microlens directly, that is, the encapsulation material can contact with the surface of the microlens without retaining an air gap between the encapsulation material and the microlens, which can improve the reliability of the device, and reduce the encapsulation difficulty effectively. Particularly, for a vehicle device, reducing formation of the air gap is advantageous for passing the vehicle regulation certification.

In an optional solution of this disclosure, the microlens array is formed on a surface of the photosensitive pixel directly. The microlens array is integrated with the photosensitive pixel directly, which not only can improve the integration level of the device and improve the stability of the device effectively, but also can reduce assembly steps in the later stage and reduce the assembly difficulty.

In an optional solution of this disclosure, the microlens is a planar lens, that is, in the microlens, heights of surfaces of all protrusions are the same. Surfaces through which the light transmitting are all flat planes, instead of curved surfaces. A surface of the microlens facing the encapsulation material is parallel to the surface of the photosensitive pixel. Using planar lens and reducing curved surfaces can ensure the controllability of the manufacturing process effectively, and can ensure the accuracy of the microlens effectively.

## BRIEF DESCRIPTION OF DRAWINGS

To more clearly describe the technical solutions of the embodiments of this disclosure or the prior art, the drawings to be used in the description of the embodiments or the prior art are briefly introduced below. Apparently, the drawings described below are merely some embodiments of this disclosure. For those of ordinary skills in the art, other drawings may also be obtained based on these drawings without making creative work.

FIG. 1 shows a schematic diagram of a cross-sectional structure of a detector unit;

FIG. 2 shows a schematic diagram of a cross-sectional structure of a detector unit in a first embodiment of this disclosure;

FIG. 3 shows a schematic diagram of a light path configuration for converging light by a microlens in a microlens array of the detector unit shown in FIG. 2;

FIG. 4 shows a schematic diagram of magnified structure of the microlens shown in FIG. 3;

FIG. 5 shows a schematic diagram of phase distribution of light during transmission of the light through the microlens shown in FIG. 3;

FIG. 6 shows a schematic diagram of phase distribution of light during transmission of the light through a microlens of a detector unit in a second embodiment of this disclosure;

FIG. 7 shows a relationship between a protrusion in a metalens and a transmission phase of the detector unit in the embodiment shown in FIG. 6;

FIG. 8 shows a schematic diagram of a cross-sectional structure of a detector unit in a third embodiment of this disclosure;

FIG. 9 shows focusing of parallel incident light by a microlens of the detector unit in the embodiment shown in FIG. 8;

FIG. 10 shows a schematic structural diagram of a detector unit in a fourth embodiment of this disclosure;

FIG. 11 shows focusing of parallel incident light by a microlens of the detector unit in the embodiment shown in FIG. 10; and

FIG. 12 shows focusing of parallel incident light by a microlens of a detector unit in a fifth embodiment of this disclosure.

## DETAILED DESCRIPTION

As can be known from the BACKGROUND, a colored fingerprint imaging module in the prior art has a problem of poor imaging effects. Here, reasons for the problem of the poor imaging effects are analyzed based on a structure of the fingerprint imaging module.

As can be known from the BACKGROUND, even if a microlens array is provided in the prior art, detection efficiency of a detector unit is still low. Here, reasons for the problem of the low detection efficiency are analyzed based on a structure of a detector unit.

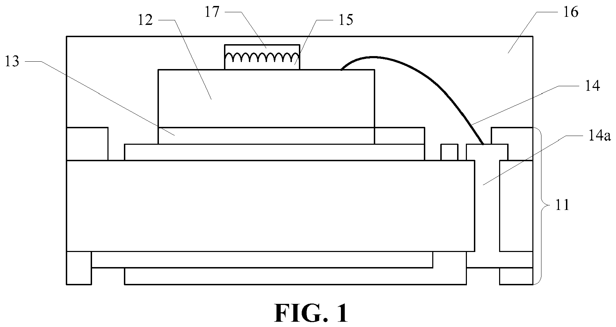

As shown in FIG. 1, a schematic diagram of a cross-sectional structure of a detector unit is shown.

The detector unit includes: a substrate 11; a photosensitive pixel 12, the photosensitive pixel 12 being located on the substrate 11, one side of the photosensitive pixel 12 being connected and fixed to the substrate 11 through a conductive silver adhesive 13; the other side of the photosensitive pixel 12 being connected to an interconnection structure 14a in the substrate 11 through a connection wire 14; and a microlens array 15, the microlens array 15 being located on the photosensitive pixel 12.

The photosensitive pixel 12 includes multiple photosensitive devices (not shown in the figure). The photosensitive device is a single photon photosensitive device, such as a SPAD device array or a SiPM device. The microlens array 15 includes multiple microlenses. The microlenses have a one-to-one relationship with the photosensitive devices. The microlenses can converge a light signal to a photosensitive region of a corresponding photosensitive device.

The microlens array 15 is usually manufactured using, for example, a photoresist melting technology (that is, melting a cube-shaped photoresist to form a spherical shape), a nanoimprinting technology, or the like. These manufacturing methods are less accurate in controlling the appearance and precision of the microlenses, and the microlens array also tends to have a filling factor lower than 100%, which changes refraction effect of the microlens array, resulting in unstable optical performance, making it difficult to converge the light signal to the photosensitive region of the photosensitive device accurately, and resulting in low detection efficiency of the detector unit.

Further, the microlens array cannot be completely filled, with the filling factor lower than 100%, which can also cause unpredictable gaps in the microlens array and the detector unit, which can cause reliability risks for the device.

In addition, as shown in FIG. 1, the detector unit further includes: an encapsulation layer 16. The encapsulation layer 16 covers the substrate 11, the photosensitive pixel 12, and the microlens array. In the prior art, a most reliable and most inexpensive encapsulation solution is an encapsulation solution based on an organic material, that is, the material of the encapsulation layer 16 is an organic material. The material of the microlens array 15 manufactured using, for example, the photoresist melting technology (that is, melting a cube-shaped photoresist to form a spherical shape), the nanoimprinting technology, or the like is usually also an organic material.

In such a case, a refractive index of the material of the microlens array 15 is very close to a refractive index of the material of the encapsulation layer 16. In case of direct encapsulation, that is, the encapsulation layer 16 covers a surface of the microlens array 15 directly, the direct contact between the encapsulation layer 16 and the surface of the microlens array 15 can cause the refractive indexes of the materials on both sides of the interface between the microlens array 15 and the encapsulation layer 16 to be too close, which can affect or even eliminate the refraction effect of the microlenses, and weaken or even disable the light converging ability of the microlenses.

To ensure the optical effects while realizing encapsulation, an air gap 17 is provided between the microlens array 15 and the encapsulation layer 16, that is, the encapsulation layer 16 does not contact with an optical surface of the microlens array 15 directly, and air is retained below the encapsulation layer 16 and above the microlens array 15. However, the air is greatly affected by an environment. The presence of the air gap 17 can reduce the reliability of the device, also impose very high requirements for the encapsulation process, and increase the complexity of the encapsulation process.

Particularly, when the detector unit is used in a vehicle LiDAR, the presence of the air gap 17 is a big challenge for the vehicle regulation certification.

To solve the technical problems, this disclosure provides a detector unit, including:
a photosensitive pixel including multiple photosensitive devices; and a microlens array located on a side of the photosensitive pixel, a light is incident on the side. The microlens array includes multiple microlenses. The microlenses have a one-to-one relationship with the photosensitive devices. The microlenses includes a protrusion, and a material of the protrusion is an inorganic material.

In technical solutions of this disclosure, the material of the protrusion used to converge light is an inorganic material. A refractive index of the material of the protrusion is different from a refractive index of an encapsulation material of the detector unit. In such a case, encapsulation can be performed on a surface of the microlens directly, that is, the encapsulation material can contact with the surface of the microlens directly without retaining an air gap between the encapsulation material and the microlens, which can improve the reliability of the device, and reduce the encapsulation difficulty effectively. Particularly, for a vehicle device, reducing formation of the air gap is advantageous for passing the vehicle regulation certification.

To make the above objects, features, and advantages of this disclosure more obvious and understandable, specific embodiments of this disclosure are described in detail below with reference to the drawings.

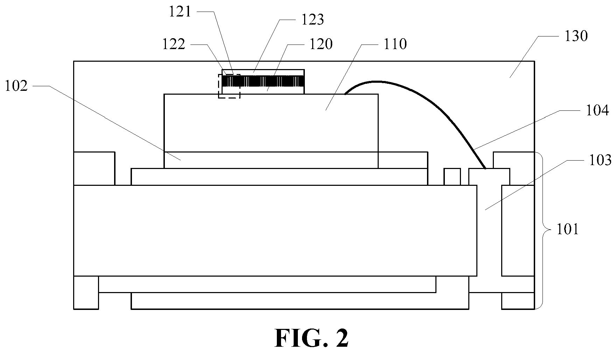

Referring to FIG. 2, a schematic diagram of a cross-sectional structure of a detector unit in an embodiment of this disclosure is shown.

The detector unit includes: a photosensitive pixel 110, the photosensitive pixel 110 including multiple photosensitive devices (not shown in the figure); and a microlens array 120. The microlens array 120 is located on a side of the photosensitive pixel 110, a light is incident on the side. The microlens array 120 includes multiple microlenses 121. The microlenses 121 have a one-to-one relationship with the photosensitive devices. The microlenses 121 includes a protrusion 122. The material of the protrusion 122 is an inorganic material.

The material of the protrusion 122 used to converge light is an inorganic material. A refractive index of the material of the protrusion 122 is different from a refractive index of an encapsulation material of the detector unit. In such a case, encapsulation can be performed on a surface of the microlens 121 directly without affecting its optical performance, that is, the surface of the microlens 121 can contact with the encapsulation material directly without affecting the optical performance. There is no need of retaining an air gap between the microlens 121 and the encapsulation material, which can improve the reliability of the device, and reduce the encapsulation difficulty effectively. Particularly, for a vehicle device, reducing formation of the air gap is advantageous for passing the vehicle regulation certification.

The photosensitive pixel 110 can receive a light signal and convert the light signal into an electrical signal. The photosensitive pixel 110 includes multiple photosensitive devices arranged in an array.

In some embodiments of this disclosure, the photosensitive device is a single photon detector device. Specifically, the photosensitive device includes: a SPAD device. The SPAD (Single Photon Avalanche Device) device, that is, a single photon avalanche diode, is an avalanche photodiode working in a Geiger mode, and can be used to detect a weak light signal or even a single photon signal. Application forms of photodetectors mainly include SPAD arrays or silicon photomultipliers (SiPMs).

In some embodiments of this disclosure, the photosensitive pixel 110 is located on the substrate 101. One side of the photosensitive pixel 110 is connected and fixed to the substrate 101 through a conductive silver adhesive 102, and the other side of the photosensitive pixel 110 is connected to an interconnection structure 103 in the substrate 101 through a connection wire 104.

The microlens array 120 can adjust the light incident on the photosensitive pixel 110.

Specifically, the microlens array 120 includes multiple microlenses arranged in an array. The multiple microlenses have a one-to-one relationship with the multiple photosensitive devices, that is, the microlens can adjust the light incident on a corresponding photosensitive device.

The microlens includes a protrusion 122. The protrusion 122 can converge light. Specifically, the material of the protrusion 122 is an inorganic material. The refractive index of the protrusion 122 is greatly different from the refractive index of the encapsulation material used in post-encapsulation process. In such a case, optical performance is not be affected even if the protrusion 122 contacts with the encapsulation material directly. That is to say, encapsulation can be performed on the surface of the protrusion 122 of the microlens 121 directly without retaining the air gap.

In some embodiments of this disclosure, the photosensitive device is a single photon detector, in such a case, the microlens in the microlens array 120 can converge a transmitted light signal to a depletion layer of the corresponding photosensitive device. A region used to transmit a light signal on a surface of the single photon detector is a photosensitive surface. Components such as an electrode, a light isolation structure, or the like need to be manufactured around the photosensitive surface. In such a case, a filling factor determined based on a comparison between the photosensitive surface of the photosensitive device and a total surface area of the photosensitive device is relatively small, but only photons that are incident on the photosensitive region (i.e., the depletion layer) through the photosensitive surface can be detected by the photosensitive device effectively. Therefore, the arrangement of the microlenses can enhance the intensity of light incident on the depletion layer of the corresponding photosensitive device effectively, which can improve the detection efficiency of the single photon detector.

In some embodiments of this disclosure, the inorganic material is silicon (with a refractive index of about 3.5). Manufacturing the protrusion 122 using a silicon material can minimize light loss through waveband selection. And silicon selected as the material of the protrusion 122 can be compatible with the manufacturing process of the photosensitive pixel 110. The photosensitive pixel 110 and the microlens array 120 can be manufactured in the same process flow.

It should be noted that in some embodiments of this disclosure, the microlens includes a base (not shown in the figure). The protrusion 122 is located on a surface of the base, and the base and the protrusion 122 are an integrated structure. In some other embodiments of this disclosure, the microlens can only include the protrusion 122.

In some embodiments of this disclosure, the microlens array 120 is formed on the surface of the photosensitive pixel 110. The microlens array 120 is formed on the surface of the photosensitive pixel 110 directly. A surface of the microlens array 120 facing the photosensitive pixel 110 contacts with a surface of the photosensitive pixel 110 facing the microlens array 120 directly. The lens array is formed on the surface of the photosensitive pixel 110 directly. The microlens array 120 is integrated with the photosensitive pixel 110 directly, which not only can improve the integration level of the device and improve the stability of the device effectively, but also can reduce assembly steps in the later stage and reduce the assembly difficulty.

In some embodiments of this disclosure, the detector unit further includes: a cladding material 123. The cladding material 123 fills at least a gap between adjacent protrusions 122, and a refractive index of the cladding material 123 is lower than a refractive index of the material of the protrusions 122. The cladding material 123 is filled between the protrusions 122 to protect and enhance. Specifically, the refractive index of the cladding material 123 is lower than the refractive index of the material of the protrusions 122. For example, the cladding material 123 may be a polymer, a silicon compound, or the like.

In some embodiments of this disclosure, a top surface of the cladding material 123 is higher than a top surface of the protrusions 122. The top surface of the cladding material 123 is made higher than the top surface of the protrusions 122, in such a case, the cladding material 123 can completely cover the protrusions 122, which can protect the protrusions effectively and facilitate subsequent encapsulation.

In some embodiments of this disclosure, the detector unit further includes: an encapsulation layer 130. The encapsulation layer located at least on the microlens array 120. The encapsulation layer can protect the detector unit. In some embodiments of this disclosure, the top surface of the cladding material filled between the protrusions is higher than the top surface of the protrusions 122, in such a case, the encapsulation layer contacts with the cladding material 123 directly, that is, encapsulation is performed on the surface of the cladding material 123 directly. In some other embodiments of this disclosure, when the protrusions 122 are exposed from the cladding material 123 or the detector unit does not include the encapsulation layer, the encapsulation material contacts with the surface of the protrusions directly, that is, encapsulation is performed on the surface of the microlens array 120 directly.

In some embodiments of this disclosure, a process of forming the microlens array 120 includes: a deposition process. Specifically, the process of forming the microlens array 120 includes: depositing a lens material layer on the surface of the photosensitive pixel 110; forming a patterned layer on the surface of the lens material layer, a to-be-etched region of the lens material layer being exposed from the patterned layer; and etching the microlens material layer using the patterned layer as a mask, to form a microlens array 120 with the protrusions. In some embodiments, the cladding material 123 is further filled between the adjacent protrusions 122. In such a case, after the etching to form the microlens array 120, the process further includes: filling the cladding material 123 between the adjacent protrusions.

As shown in FIG. 2, in some embodiments of this disclosure, the microlens is a planar microlens, that is, in the microlens, heights of surfaces of all protrusions are the same, and surfaces through which light transmits are all flat planes, instead of curved surfaces. Specifically, a surface of the microlens facing the encapsulation material is parallel to the surface of the photosensitive pixel 110. Using planar lens and avoiding curved surfaces can ensure the controllability of the manufacturing process effectively, and can ensure the accuracy of the microlens effectively.

Specifically, in some embodiments of this disclosure, the microlens includes: multiple protrusions 122. The microlens is a diffractive lens, that is, light is diffracted during projection onto the multiple protrusions 122 to achieve convergence effects.

The microlens is a diffractive lens. The microlens does not rely on the refraction effect caused by the difference in surface refractive index. In such a case, no matter whether the surface of the microlens is air or an encapsulation material with a different refractive index, it will not affect the diffraction effect of the microlens, that is, the optical performance of the microlens is not affected by the material it contacts with, and it can contact with the encapsulation material directly.

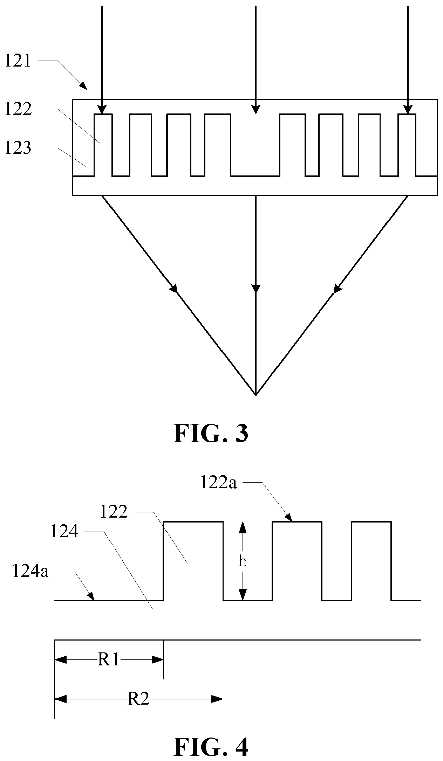

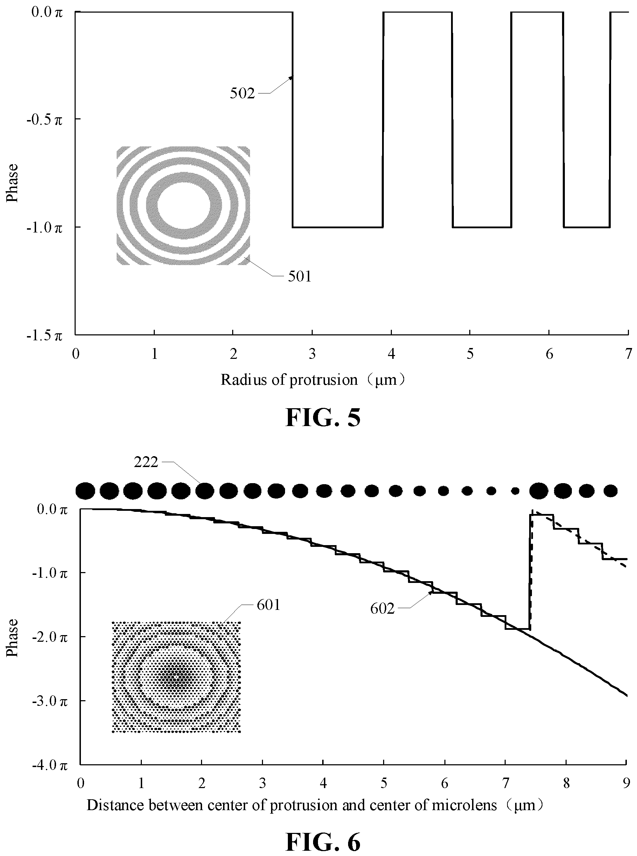

Referring to FIGS. 3 to 5, FIG. 3 shows a schematic diagram of a light path configuration for converging light by a microlens in a microlens array 120 of the detector unit shown in FIG. 2; FIG. 4 shows a schematic diagram of magnified structure of the microlens shown in FIG. 3; and FIG. 5 shows a schematic diagram of phase distribution of light during transmission of the light through the microlens shown in FIG. 3.

In some embodiments of this disclosure, the microlens 121 is a Fresnel zone plate ("FZP"). The Fresnel zone plate is formed of a series of protruding rings with different radiuses and different widths. When the microlens is a Fresnel zone plate, in a plane parallel to the surface of the photosensitive pixel 110, a section of the protrusion 122 is annular, and the multiple protrusions 122 are distributed in a concentric annulus (shown as a small picture 501 in FIG. 5).

As shown in FIG. 5, the horizontal axis represents the section radius of the protrusion 122, and the longitudinal axis represents the phase. Line 502 represents a surface profile of the microlens. Specifically, with reference to FIG. 4, a phase difference between a top surface 122a of the protrusions 122 and a surface 124a of a base 124 between the protrusions 122 is $\pi$, that is, a phase difference between top surfaces of the rings and a bottom surface of a gap between the rings is $\pi$.

In such a case, by controlling a height h of the protrusions 122 protruding from the surface 124a of the base 124, the phase difference between the top surfaces 122a of the protrusions 122 and the surface 124a of the base 124 between the protrusions 122 satisfies predetermined requirements. A relationship between the phase difference between the top surfaces 122a of the protrusions 122 and the surface 124a of the base 124 between the protrusions 122 and the height h of the protrusions 122 protruding from the base 124 satisfies:

$$\Delta\varphi = 2\pi \frac{h(n-n_0)}{\lambda}$$

where n is the refractive index of the material of the protrusions 122, $n_0$ is the refractive index of the gap material between the protrusions 122, and $\lambda$ is the wavelength of the transmitted light.

In addition, the radius of the protrusion 122 satisfies:

$$R_k = \sqrt{\frac{k \cdot \lambda}{n}\left(f + \frac{k \cdot \lambda}{4n}\right)}$$

where n is the refractive index of the material below the protrusions (e.g., the base 124), and k is the ring order.

Specifically, the radius R1 in FIG. 4 represents the radius of the first order ring in the protrusions, that is, the radius of the ring with the order k=1 in the protrusions. The radius R2 in FIG. 4 represents the radius of the second order ring in the protrusions, that is, the radius of the ring with the order k=2 in the protrusions. Specific sizes of the radius R1 and the radius R2 can be determined based on the above formula of $R_k$.

Referring to FIG. 6, a schematic diagram of phase distribution of light during transmission of the light through a microlens of a detector unit in another embodiment of this disclosure is shown.

In an embodiment of this disclosure, the microlens can further be a metalens. The metalens is composed of periodically arranged structural units with different sectional sizes. Each structural unit corresponds to a different phase change. Structural units corresponding different positions are arranged based on target spatial phase distribution.

In some embodiments of this disclosure, the structural unit is a cylinder or a cuboid. In such a case, when the microlens is a metalens, in a plane parallel to the surface of the photosensitive pixel, a section of the protrusion 222 is annular or rectangular, and sectional sizes of the multiple protrusions 222 are different. And the multiple protrusions 222 are distributed in a plane parallel to the surface of the photosensitive pixel based on a predetermined rule (shown as a small picture 601 in FIG. 6).

As shown in FIG. 6, the structural units (the protrusions 222) are illustrated as cylinders, the horizontal axis represents a distance between the center of the protrusions 222 and the center of the microlens, and the longitudinal axis represents the phase. Line 602 represents the phase at different positions of the microlens. The distance between the center of the protrusions 222 and the center of the microlens is represented as r, and the phase at r satisfies:

$$\varphi(r) = \left[\frac{2\pi}{\lambda}\left(\sqrt{(r^2 + f^2)} - f\right)\right] \bmod(2\pi)$$

Each of the protrusions 222 can cause a phase delay, and the following theoretical computation can be performed based on a waveguide model:

$$\varphi_{WG} = \frac{2\pi}{\lambda} n_{eff} H$$

where λ is the wavelength of the transmitted light, $n_{eff}$ is the effective refractive index of the fundamental mode of transmission in the protrusions 222, and H is the height of the protrusions 222.

The height H of each of the protrusions 222 is equal, and the phase delay caused by each of the protrusions 222 is mainly associated with the sectional size of the protrusion 222 (that is, the sectional size of the protrusion 222 affects $n_{eff}$).

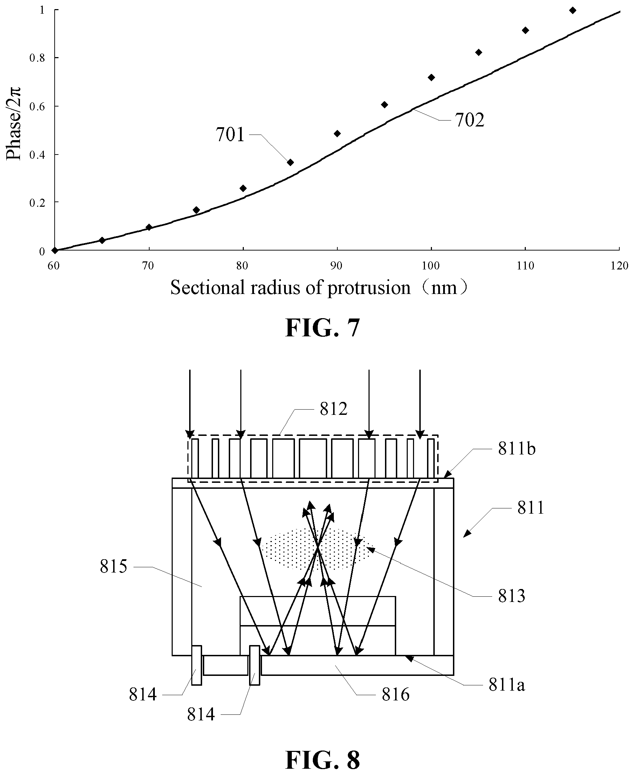

Referring to FIG. 7, a relationship between a protrusion in a metalens and a transmission phase of the detector unit in the embodiment shown in FIG. 6 is shown.

Specifically, the protrusion 222 of the microlens is a cylinder. In FIG. 7, the horizontal axis represents the sectional radius of the protrusion 222, the longitudinal axis represents the transmission phase, the data line 701 represents a result of the finite difference time domain ("FDTD") simulation, and the data line 702 represents a computation result based on the waveguide model.

It should be noted that the actual design can be based on the simulation result or theoretical computation based on the above formula. Alternatively, the actual design can be based on the simulation results with reference to the computation results based on the waveguide model.

As can be seen from the above description, the microlens in some embodiments of this disclosure is a diffractive lens, and the structural size of the microlens is associated with the wavelength of the transmitted light. The structural size of the microlens is determined based on the wavelength (working wavelength) of light to be sensed by the photosensitive device. In such a case, the best focusing effect for incident light at the working wavelength can be ensured, and interference light outside the working wavelength can be not focused effectively, which can reduce the impact of interference light on the sensing device.

Referring to FIGS. 6 and 7, the size of the protrusion 222 is associated with the required phase delay at the position of the protrusion 222. In such a case, a required phase difference of the protrusions 222 at different positions is determined based on a predetermined focal length f and distance r, and then the sectional size of the protrusion 222 is determined based on the phase difference.

It should be noted that in some embodiments of this disclosure, the detector unit further includes: an air gap. The air gap located at least between adjacent protrusions 222. The refractive index of air is very low. Retaining an air gap between adjacent protrusions 222 can increase the refractive index difference between the protrusions 222 and the surrounding environment to ensure good optical performance, while keeping the manufacturing process relatively simple and low impact on encapsulation.

It should be further noted that in some embodiments of this disclosure, the focal length of the microlens is larger than a distance from the surface of the photosensitive device to the depletion layer. The distance is a vertical distance from the depletion layer to the surface of the photosensitive device. Increasing the focal length of the microlens and reducing its numerical aperture with the diameter remaining unchanged is advantageous for reducing the manufacturing difficulty and improve the manufacturing accuracy and focusing effect of the microlens. The microlens of this disclosure has a relatively large focal length, and can be used in a back side illumination photosensitive device and a front side illumination photosensitive device.

Referring to FIG. 8, a schematic diagram of a cross-sectional structure of a detector unit in still another embodiment of this disclosure is shown.

In some embodiments of this disclosure, the microlens 812 can converge a light signal to a high electric field region 813 of a corresponding photosensitive device 811, that is to say, a focal length of the microlens 812 satisfies a predetermined condition, to converge light to the high electric field region 813 of the corresponding photosensitive device 811.

As shown in FIG. 8, in some embodiments of this disclosure, the photosensitive device 811 is a back side illumination ("BSI") photosensitive device 811, that is to say, an electrode 814 of the photosensitive device 811 is located on one side, and the light is incident on the other side of the photosensitive device 811. The high electric field region 813 is located in a depletion layer of the photosensitive device 811.

Specifically, the photosensitive device 811 includes a first surface 811a provided with the electrode 814 and a second surface 811b opposite to the first surface 811a. The microlens array is located on a side of the second surface 811b. Therefore, the photosensitive device 811 includes an epitaxial layer 815, the epitaxial layer 815 can absorb photons to achieve detection; an electrode 814, the electrode 814 being located on a surface on a side of the epitaxial layer 815; and the microlens 812 located on a surface on a side of the epitaxial layer 815 away from the electrode 814. The light signal is incident on the epitaxial layer 815 after being transmitted through the microlens 812. The microlens 812 converges the transmitted light to the high electric field region 813 in the epitaxial layer 815.

In some embodiments of this disclosure, the light signal is reflected from the first surface 811a of the photosensitive device 811 after transmitting sequentially through the microlens array and the photosensitive device 811. After the light is incident on the epitaxial layer 815, partial light signal is absorbed by the epitaxial layer 815 to achieve detection; partial light transmits through the epitaxial layer 815 and is reflected from the surface on the side provided with the electrode 814, and is re-incident on the epitaxial layer 815 to increase a probability of being absorbed and detected.

In some embodiments of this disclosure, the detector unit further includes: a reflective layer 816. The reflective layer 816 is located on the first surface 811a of the photosensitive device 811. The reflective layer 816 can increase a probability that the light transmitting through the photosensitive device 811 can be reflected from the first surface 811a of the photosensitive device 811.

For the microlens array, the microlenses 812 tend to have large diameters and short focal lengths. In such a case, typically, the microlenses 812 in the microlens array tend to have large numerical apertures ("NA"). And it is difficult to process a lens with a large numerical aperture. However, in the embodiment shown in FIG. 8, the focal length of the microlens 812 enables the incident light to be focused on the focal point after being reflected from the electrode 814 or the reflective layer 816 , which can increase the focal length of the microlens 812 with the diameter remaining unchanged, reduce the numerical aperture of the microlens 812 effectively, and reduce the manufacturing difficulty of the microlens 812. Particularly, when the microlens 812 is a metalens, the reduction of the numerical aperture can further improve the transmittance rate and focusing effect of the microlens 812 effectively.

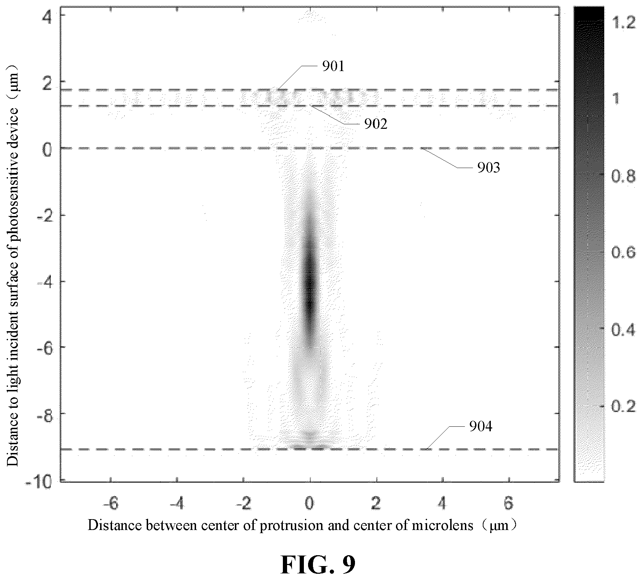

Referring to FIG. 9, focusing of parallel incident light by the microlens 812 of the detector unit in the embodiment shown in FIG. 8 is shown.

It should be noted that in the embodiment shown in FIG. 8, the microlenses 812 in the microlens array are metalenses.

Specifically, the horizontal axis represents a distance between the center of the protrusions and the center of the microlenses 812, and the longitudinal axis represents a distance to a surface of the photosensitive device 811 where light is incident. In FIG. 9, a region between a dotted line 901 and a dotted line 902 corresponds to the metalens, a region between the dotted line 902 and a dotted line 903 corresponds to a dielectric layer covering the epitaxial layer 815 in the photosensitive device 811 (the dielectric layer can serve the function for isolation, protection, and anti-reflection. The material of the dielectric layer includes at least one of silicon oxide and silicon nitride), a region between the dotted line 903 and a dotted line 904 corresponds to the epitaxial layer 815 of the photosensitive device 811, and a region between the dotted line 904 and the horizontal axis corresponds to the electrode 814.

As shown in FIG. 9, the combination of the back side illumination photosensitive device 811, the electrode 814, and the reflective layer 816 can extend the focal length of the microlens 812 effectively. In such a case, the light is reflected from the electrode 814 and the reflective layer 816 and then converged to the high electric field region 813 of the epitaxial layer 815 of the photosensitive device 811, and the microlens 812 can focus light effectively. Specifically, in the embodiment where the back side illumination photosensitive device 811 is combined with the electrode 814 and the reflective layer 816, the focal length of the microlens 812 should be a sum of the thickness of the epitaxial layer 815 of the photosensitive device 811 and a distance from the surface of the reflective layer 816 to the high electric field region 813.

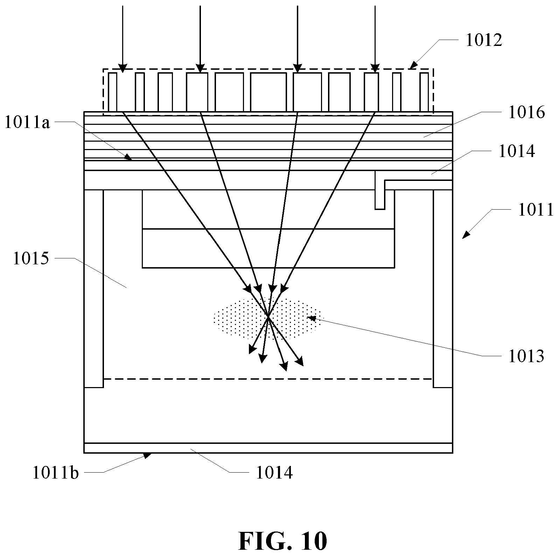

Referring to FIG. 10, a schematic structural diagram of a detector unit in another embodiment of this disclosure is shown.

In some embodiments of this disclosure, the photosensitive device 1011 is a front side illumination ("FSI") photosensitive device, that is to say, the light is incident on a side of the photosensitive device 1011 provided with an electrode 1014.

Specifically, the photosensitive device 1011 includes a first surface 1011a provided with the electrode 1014 and a second surface 1011b opposite to the first surface 1011a; and the microlens array is located on a side of the first surface 1011a. In such a case, the electrode 1014 of the photosensitive device 1011 and the microlens array are stacked sequentially on a surface of a side of an epitaxial layer of the photosensitive device 1011. The light signal is incident on the epitaxial layer after transmitting through the microlens 1012. The microlens 1012 converges the transmitting light to the high electric field region 1013 in the epitaxial layer. The high electric field region 1013 is located in a depletion layer of the photosensitive device 1011.

It should be noted that in the embodiment shown in FIG. 10, the photosensitive device 1011 includes 2 electrodes, one of the electrodes 1014 is located on the first surface 1011a, and the other electrode 1014 is located on the second surface 1011b. There is a relatively thick substrate region between the electrode 1014 and the high electric field region 1013 of the FSI device. Light can be completely absorbed during propagation in the substrate, and cannot be reflected back to the high electric field region from the electrode 1014.

As shown in FIG. 10, in some embodiments of this disclosure, the microlens 1012 further includes: a filler layer 1016. The filler layer 1016 is located on the first surface 1011a of the photosensitive device 1011. The filler layer 1016 can increase a distance between the microlens 1012 and the high electric field region 1013 of the corresponding photosensitive device 1011, which can achieve the purpose of increasing the focal length and reducing the numerical aperture; and further keep converged light away from the electrodes to improve the detection efficiency.

Specifically, the material of the filler layer 1016 is a low light loss material. Using the low light loss material to manufacture the filler layer 1016 can reduce the loss when light transmits through the filler layer 1016 effectively, and improve the detection efficiency effectively. For example, the material of the filler layer 1016 can be silicon oxide. The silicon oxide material is highly compatible with the manufacturing process of the photosensitive device 1011 and the microlens array, and can reduce the impact of the arrangement of the filler layer 1016 effectively. The thickness of the filler layer 1016 is determined based on the numerical aperture of the microlens 1012 and process limitations. That is to say, the numerical aperture of the microlens 1012 is designed based on the process limitations to determine a shortest focal length f, and then determine the thickness of the filler layer 1016 based on the focal length f. That is, the thickness of the filler layer 1016 is the focal length f minus a distance from the surface of the photosensitive device 1011 to the high electric field region.

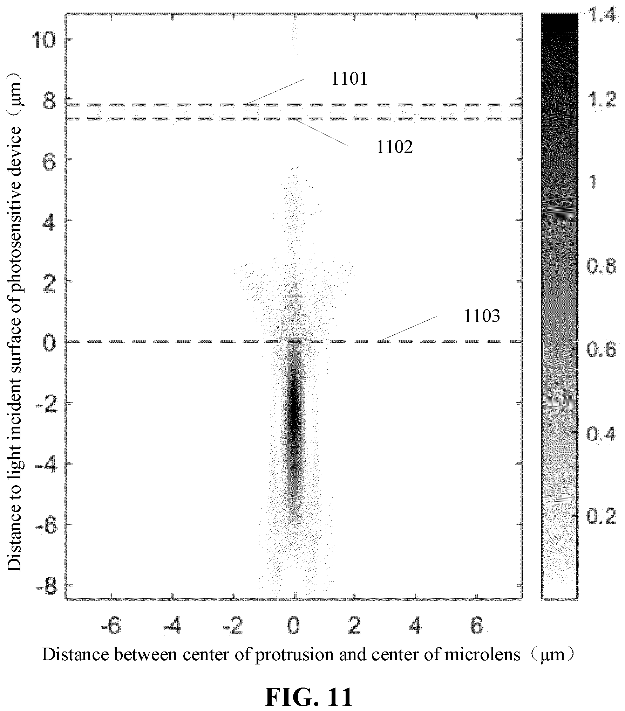

Referring to FIG. 11, focusing of parallel incident light by the microlens 1012 of the detector unit in the embodiment shown in FIG. 10 is shown.

It should be noted that in the embodiment shown in FIG. 10, the microlenses 1012 in the microlens array are metalenses.

Specifically, the horizontal axis represents a distance between the center of the protrusions and the center of the microlenses 1012, and the longitudinal axis represents a distance to a surface of the photosensitive device 1011 where light is incident. In FIG. 11, a region between a dotted line 1101 and a dotted line 1102 corresponds to the metalens, a region between the dotted line 1102 and a dotted line 1103 corresponds to the filler layer 1016, and a region between the dotted line 1103 and the horizontal axis corresponds to an epitaxial layer of the photosensitive device 1011.

As shown in FIG. 11, after transmitting through the metalens and the filler layer 1016, the light is focused on the epitaxial layer of the photosensitive device 1011, and on a high electric field region close to a PN junction formed in the epitaxial layer, which can ensure that the light signal is concentrated in the high electric field region, increase a probability for the light signal to be absorbed and to excite carriers effectively, trigger avalanche effects, and improve the effective detection of the light signal effectively.

It should be noted that in the foregoing embodiments, the microlenses are all meta-microlenses. The metalenses have higher focusing efficiency, and can more improve the detection efficiency effectively. However, the implementation of combining the meta-microlens with the back side illumination photosensitive device, or combining the meta-microlens with the front side illumination photosensitive device is just an example. In other embodiments of this disclosure, the microlens combined with the back side illumination photosensitive device or the microlens combined with the front side illumination photosensitive device can also be a Fresnel zone plate.

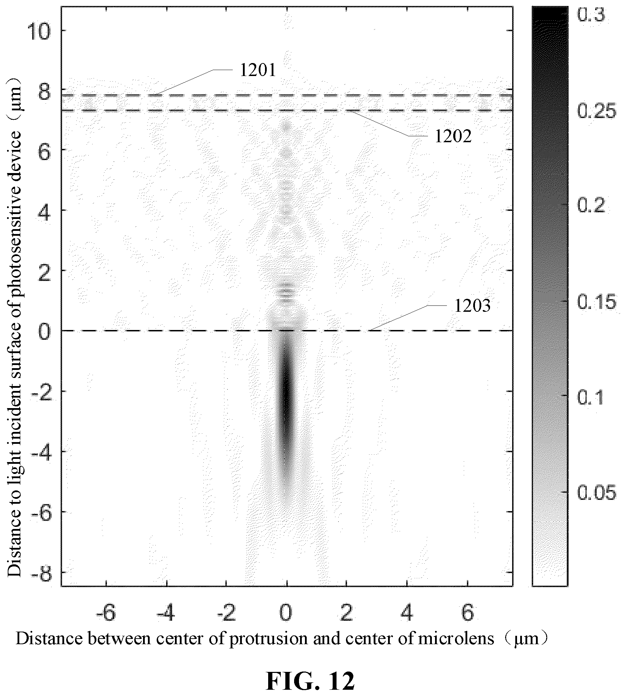

Referring to FIG. 12, focusing of parallel incident light by the microlens of the detector unit in yet another embodiment of this disclosure is shown.

It should be noted that in the embodiment shown in FIG. 12, the microlenses in the microlens array are Fresnel zone plates. The photosensitive device is a front side illumination photosensitive device, and a filler layer is also provided between the microlens and the photosensitive device.

Specifically, the horizontal axis represents the radius of the protrusion, and the longitudinal axis represents a distance to a surface of the photosensitive device where light is incident. In FIG. 12, a region between a dotted line 1201 and a dotted line 1202 corresponds to the Fresnel zone plate, a region between the dotted line 1202 and a dotted line 1203 corresponds to the filler layer, and a region between the dotted line 1203 and the horizontal axis corresponds to an epitaxial layer of the photosensitive device.

As shown in FIG. 12, the Fresnel zone plate can also focus the incident light on the high electric field regions. The larger size of the Fresnel zone plate can reduce manufacturing difficulty, and improve the yield effectively.

Accordingly, this disclosure further provides a detector array, specifically including: detector units arranged in an array. The detector units are the detector units described in this disclosure.

Because the detector units are the detector units described in this disclosure, specific technical solution of the detector units refers to the foregoing embodiments of the detector units, which is not repeated here in this disclosure.

The material of the protrusion used to converge light of the microlens in the detector unit is an inorganic material. A refractive index of the material of the protrusion is different from a refractive index of an encapsulation material of the detector unit. In such a case, encapsulation can be performed on a surface of the microlens directly, that is, the encapsulation material can contact with the surface of the microlens without retaining an air gap between the encapsulation material and the microlens, which can improve the reliability of the device effectively, and reduce the encapsulation difficulty. Particularly, for a vehicle device, reducing formation of the air gap is advantageous for passing the vehicle regulation certification.

Accordingly, this disclosure further provides a detector array motherboard, specifically including: multiple detector arrays. The detector arrays are the detector arrays described in this disclosure.

Because the detector arrays are the detector arrays described in this disclosure, for specific technical solution of the detector arrays, reference is made to the foregoing embodiments of the detector arrays, which is not repeated here in this disclosure.

In addition, this disclosure further provides a detector, including: at least one detector array. The detector array is the detector array described in this disclosure.

Because the detector array is the detector array described in this disclosure, for specific technical solution of the detector arrays, reference is made to the foregoing embodiments of the detector arrays, which is not repeated here in this disclosure.

The material of the protrusion used to converge light of the microlens in the detector unit of the detector array is an inorganic material. A refractive index of the material of the protrusion is different from a refractive index of an encapsulation material of the detector unit. In such a case, encapsulation can be performed on a surface of the microlens directly, that is, the encapsulation material can contact with the surface of the microlens without retaining an air gap between the encapsulation material and the microlens, which can improve the reliability of the device effectively, and reduce the encapsulation difficulty. Particularly, for a vehicle device, reducing formation of the air gap is advantageous for passing the vehicle regulation certification.

The detector array in the detector can be encapsulated without retaining the air gap, with low encapsulation difficulty and high reliability. The detector is more compliant with the vehicle regulation certification.

In addition, this disclosure further provides a LiDAR. The LiDAR includes: a light source used to generate light; and a detector used to receive echo light. The detector is the detector described in this disclosure.

To sum up, in the technical solutions of this disclosure, the material of the protrusion used to converge light of the microlens is an inorganic material. A refractive index of the material of the protrusion is different from a refractive index of an encapsulation material of the detector unit. In such a case, encapsulation can be performed on a surface of the microlens directly, that is, the encapsulation material can contact with the surface of the microlens without retaining an air gap between the encapsulation material and the microlens, which can improve the reliability of the device effectively, and reduce the encapsulation difficulty. Particularly, for a vehicle device, reducing formation of the air gap is advantageous for passing the vehicle regulation certification.

Further, the microlens array is formed on the surface of the photosensitive pixel directly. The microlens array is integrated with the photosensitive pixel directly, which not only can improve the integration level of the device effectively and improve the stability of the device, but also can reduce assembly steps in the later stage and reduce the assembly difficulty.

In addition, the microlens is a planar lens, that is, in the microlens, heights of surfaces of all protrusions are the same, and surfaces through which light transmits are all flat planes, instead of curved surfaces. A surface of the microlens facing the encapsulation material is parallel to the surface of the photosensitive pixel. Using planar lens and avoiding curved surfaces can ensure the controllability of the manufacturing process effectively, and can ensure the accuracy of the microlens effectively.

Although this disclosure is disclosed as above, this disclosure is not limited to the above. Any person skilled in the art may make various changes and modifications without departing from the spirit and scope of this disclosure, and therefore the scope of protection of this disclosure shall be subject to the scope limited by the claims.

## Claims

1. A detector unit, comprising:

   a photosensitive pixel comprising a plurality of photosensitive devices; and
   a microlens array located on a side of the photosensitive pixel, wherein a light is incident on the side, and the microlens array comprises a plurality of microlenses having a one-to-one relationship with the plurality of photosensitive devices, and wherein
   a microlens of the plurality of microlenses comprises a protrusion, and a material of the protrusion is an inorganic material.

2. The detector unit of claim 1, wherein the inorganic material is silicon.

3. The detector unit of claim 1 or 2, wherein the microlens array is formed on a surface of the photosensitive pixel.

4. The detector unit of claim 1, wherein a process of forming the microlens array comprises a deposition process.

5. The detector unit of claim 1, wherein the microlens is a planar microlens.

6. The detector unit of claim 5, wherein the microlens comprises a plurality of protrusions, and the microlens is a diffractive lens.

7. The detector unit of claim 6, wherein the microlens is at least one of a Fresnel zone plate or a metalens.

8. The detector unit of any of claims 1 and 5-7, wherein the microlens is configured to converge a light signal to a high electric field region of a corresponding photosensitive device.

9. The detector unit of claim 8, wherein the photosensitive device is a back side illumination photosensitive device;

   the photosensitive device comprises a first surface provided with an electrode and a second surface opposite to the first surface; and
   the microlens is located on a side of the second surface.

10. The detector unit of claim 9, further comprising:
    a reflective layer located on the first surface of the photosensitive device.

11. The detector unit of claim 9, wherein the light signal is reflected from the first surface of the photosensitive device after being transmitted through the microlens array and the photosensitive device sequentially.

12. The detector unit of claim 8, wherein the photosensitive device is a front side illumination photosensitive device;

    the photosensitive device comprises a first surface provided with an electrode and a second surface opposite to the first surface; and
    the microlens array is located on a side of the first surface.

13. The detector unit of claim 12, wherein the microlens further comprises:
    a filler layer located on the first surface of the photosensitive device.

14. The detector unit of claim 13, wherein a material of the filler layer is a low light loss material.

15. The detector unit of claim 14, wherein the material of the filler layer is silicon oxide.

16. The detector unit of claim 1, further comprising:
    a cladding material at least filling a gap between adjacent protrusions, wherein a refractive index of the cladding material is lower than a refractive index of the material of the protrusions.

17. The detector unit of claim 16, wherein a top surface of the cladding material is higher than a top surface of the protrusion.

18. The detector unit of claim 1, further comprising:
    an air gap located at least between adjacent protrusions.

19. The detector unit of any of claims 1 and 16 to 18, further comprising:
    an encapsulation layer located at least on the microlens array.

20. The detector unit of claim 1, wherein the photosensitive device is a single photon detector device.

21. The detector unit of claim 20, wherein the microlens is configured to converge a light signal to a depletion layer of a corresponding photosensitive device.

22. A detector array, comprising:
    detector units of any of claims 1-21 arranged in an array.

23. A detector array motherboard, comprising:

a plurality of detector arrays of claim 22.

24. A detector, comprising:
    at least one detector array of claim 22.

25. A LiDAR, comprising:

    a light source configured to generate light; and
    a detector of claim 24 configured to receive echo
    light.

**FIG. 1**

**FIG. 2**

121

122

123

**FIG. 3**

122a

122

124

124a

h

R1

R2

**FIG. 4**

**FIG. 5**

**FIG. 6**

**FIG. 7**

**FIG. 8**

FIG. 9

**FIG. 10**

**FIG. 11**

**FIG. 12**

## INTERNATIONAL SEARCH REPORT

| International application No. |
| --- |
| **PCT/CN2022/098331** |

| A. | CLASSIFICATION OF SUBJECT MATTER |
| --- | --- |

G01S 7/48(2006.01)i; G01S 7/481(2006.01)i; G01S 17/08(2006.01)i

According to International Patent Classification (IPC) or to both national classification and IPC

| B. | FIELDS SEARCHED |
| --- | --- |

Minimum documentation searched (classification system followed by classification symbols)

G01S

Documentation searched other than minimum documentation to the extent that such documents are included in the fields searched

Electronic data base consulted during the international search (name of data base and, where practicable, search terms used)

CNABS; CNTXT; CNKI; CJFD; 万方 WANFANG; 超星 CHAOXING; VEN; USTXT; EPTXT; WOTXT; IEEE: 上海禾赛科技有限公司, 微透镜, 阵列, 感光, 探测, 像素, 单光子, 背照, 正照, 雷达, 无机, 硅, 聚焦, 汇聚, 会聚, microlens, array, detect, pixel, photon, laser, light, sensing, silicon, inorganic, back, illuminate

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 107195647 A (IRAY TECHNOLOGY (SHANGHAI) LTD.) 22 September 2017 (2017-09-22)<br>description, paragraphs [0008]-[0110], and figures 5-13 | 1-19, 22-24 |
| X | CN 102157534 A (SAMSUNG ELECTRONICS CO., LTD.) 17 August 2011 (2011-08-17)<br>description, paragraphs [0005]-[0060], and figures 1-10 | 1-19, 22-24 |
| Y | CN 107195647 A (IRAY TECHNOLOGY (SHANGHAI) LTD.) 22 September 2017 (2017-09-22)<br>description, paragraphs [0008]-[0110], and figures 5-13 | 20-25 |
| Y | CN 113167870 A (SUTENG INNOVATION TECHNOLOGY CO., LTD.) 23 July 2021 (2021-07-23)<br>description, paragraphs [0043]-[0058], and figures 1-13 | 20-25 |
| A | CN 112859046 A (GUANGDONG OPPO MOBILE COMMUNICATIONS CO., LTD.) 28 May 2021 (2021-05-28)<br>entire document | 1-25 |

☑ Further documents are listed in the continuation of Box C.    ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **09 August 2022** | **18 August 2022** |

| Name and mailing address of the ISA/CN | Authorized officer |
| --- | --- |
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

| International application No. |
|---|
| **PCT/CN2022/098331** |

**C.    DOCUMENTS CONSIDERED TO BE RELEVANT**

| Category* | Citation of document, with indication, where appropriate, of the relevant passages | Relevant to claim No. |
|---|---|---|
| A | CN 113645376 A (NINGBO SUNNY OPTICAL TECHNOLOGY CO., LTD.) 12 November 2021 (2021-11-12)<br>    entire document | 1-25 |
| A | US 11085609 B1 (HIMAX TECHNOLOGIES LTD.) 10 August 2021 (2021-08-10)<br>    entire document | 1-25 |

Form PCT/ISA/210 (second sheet) (January 2015)

**INTERNATIONAL SEARCH REPORT**
Information on patent family members

International application No.

**PCT/CN2022/098331**

| Patent document cited in search report | | | Publication date (day/month/year) | Patent family member(s) | | | Publication date (day/month/year) |
|---|---|---|---|---|---|---|---|
| CN | 107195647 | A | 22 September 2017 | None | | | |
| CN | 102157534 | A | 17 August 2011 | US | 2011176023 | A1 | 21 July 2011 |
| | | | | JP | 2011146714 | A | 28 July 2011 |
| | | | | KR | 20110083936 | A | 21 July 2011 |
| CN | 113167870 | A | 23 July 2021 | WO | 2021196192 | A1 | 07 October 2021 |
| CN | 112859046 | A | 28 May 2021 | None | | | |
| CN | 113645376 | A | 12 November 2021 | None | | | |
| US | 11085609 | B1 | 10 August 2021 | None | | | |

Form PCT/ISA/210 (patent family annex) (January 2015)

**EP 4 446 768 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2021115033332